# EUROPEAN PATENT SPECIFICATION

(11) **EP 3 072 160 B1**
(45) Date of publication and mention of the grant of the patent: **07.08.2019**
(21) Application number: 14815037.8
(22) Date of filing: 18.11.2014
(51) Int. Cl.: H01L 31/053, H01L 31/052, H01L 31/054, H02S 40/22

(54) **PHOTOVOLTAIC PANEL**
FOTOVOLTAIKPLATTE
PANNEAU PHOTOVOLTAÏQUE

(30) Priority: 21.11.2013 IT MI20131937
(43) Date of publication of application: 28.09.2016
(73) Proprietor: Fondazione Centro Internazionale Della Fotonica Per Energia, 20133 Milano (IT)
(72) Inventor: RIGHETTI, Aldo, 20133 Milano (IT); GRASSO, Giorgio, 20133 Milano (IT)
(74) Representative: Penza, Giancarlo
(86) International application number: PCT/IB2014/066114
(87) International publication number: WO 2015/075625

(56) References cited:
- EP-A1- 1 693 901
- EP-A2- 0 789 405
- WO-A1-2013/030720
- DE-U1-202009 006 442

## Description

The present invention relates to a concentration photovoltaic panel with integrated energy storage device.

Concentration photovoltaic panels are known in which the solar radiation is concentrated on the photovoltaic material by means of an optical concentration system, in order to substitute part of the high-cost photovoltaic material with an optics that can be made with low-cost technology. The geometric gain (G) of the optical concentration systems - defined as the ratio between the solar radiation input area and the output area, the latter occupied by the photovoltaic material on which the radiation is concentrated - can range from values comprised between approximately 1 and 10, regarded as low concentration, up to values of 100 and more (high concentration), passing through intermediate values comprised between approximately 10 and 100 (medium concentration). In general, the low concentration systems, unlike the medium and high concentration systems, have the advantage that they do not require a solar tracking system (panels with static or nearly-static installation) and, due to rather high acceptance angle, allow the collection of a significant portion of the diffused light.

Examples of concentration photovoltaic panels are described in: EP0575797A1, WO2007/073203A1, DE202009006442U, US2011/0132434A1, 'Outdoor performance of a low-concentrated photovoltaic-thermal hybrid system with crystalline silicon solar cells' by Chengdong Kong et al, Applied Energy 2013 http://dx.doi.org/10.1016/j.apenergy.2013.02.011, AU-A-70929/87, WO 2013/030720A1, MI2011A002294, WO2012/017274A1.

Recently, it has proven advantageous to combine a photovoltaic plant (which typically comprises, in addition to one or more photovoltaic panels, an inverter for controlling the panels and transforming the produced current) with a storage system of the energy produced by the photovoltaic panels. In the present description and claims, the terms energy, current, etc. are referred to their electrical meaning.

Such combination is advantageous not only for the 'stand-alone' plants (i.e. disconnected from the electrical distribution network), but also in the plants connected to the network (where exchange is typically provided with the electrical distribution network), since it facilitates the onsite consumption of the current produced by the panels (so-called 'auto-consumption') and/or allows an optimization of the electrical network operation, since it increases the flexibility thereof in terms of management of the current flows from and to the network (it is observed that the storage system can in principle also store the electric energy coming from the network).

The document WO2009/011794A2 describes a photovoltaic module comprising a first and a second photovoltaic cell and an energy storage device integrated in the module.

The Applicant has noticed that the known photovoltaic panels are not free of drawbacks and/or can be improved with regard to one or more aspects.

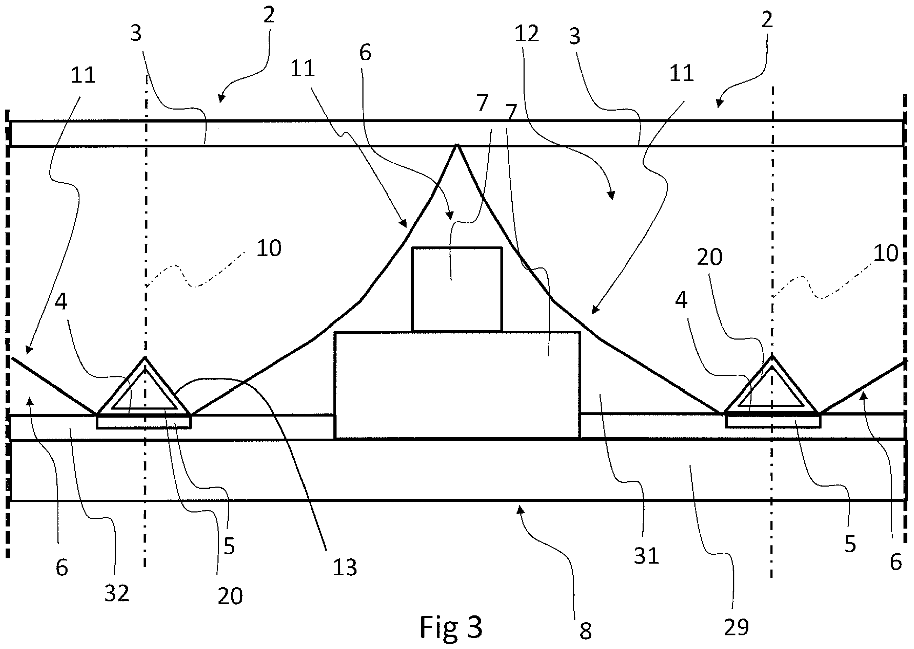

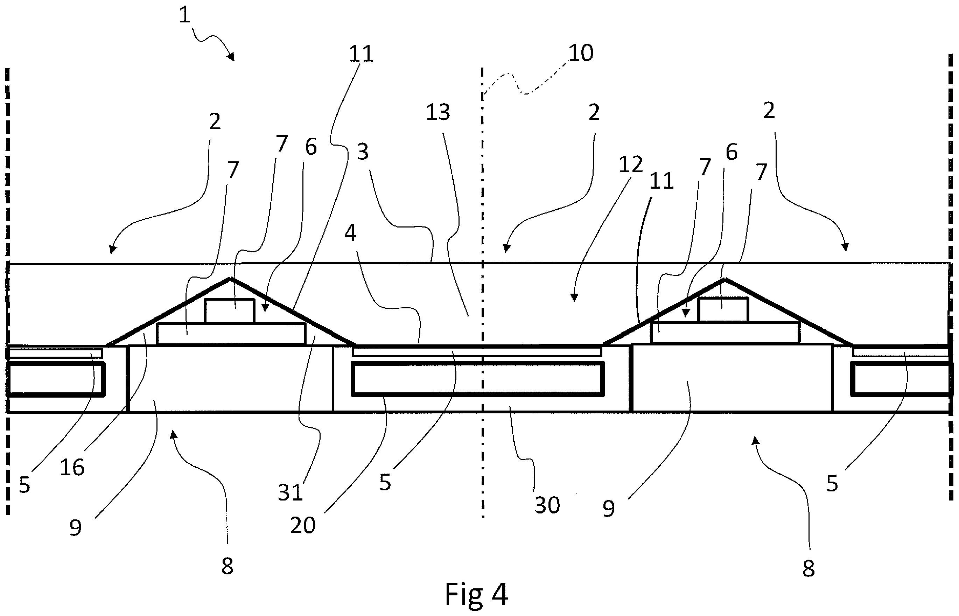

The Applicant perceived that the known photovoltaic panels with storage systems integrated in the panel do not provide an optimal storage capacity. For example, the storage device in WO2009/011794A2 is positioned either stacked with the photovoltaic cells (fig. 3) or on a side thereof (fig. 4). In the first case, the space available for the storage device is limited by the maximum size in the direction of the panel thickness (in other words, in order to increase the space available, it is necessary to increase the overall thickness of the panel, with the risk of exceeding the standard industrially-accepted thickness of the photovoltaic panels). In the second case, the space available for the storage device is limited by the aforesaid limit given by the maximum thickness and/or by the maximum size in the sense of the two main dimensions of the panel (orthogonal to the thickness), as well as by the extension of the photovoltaic cells (in other words by decreasing the latter on one hand in principle the space available for the storage device increases, and on the other hand however the power of the panel decreases, given the same size of the panel and photovoltaic material).

The Applicant has also perceived that one (or in any case a few) industrial standard was established with regard to the size, the relative structural work and the installation modes of the photovoltaic panels without solar concentration and without integrated electric energy storage (also known as 'flat photovoltaic panels'). For such purpose, the Applicant has perceived that it is advantageous, in terms of manufacturing cost and simplicity, to use the same structural work and modes of installation of the standard flat panels, also for those with electric energy storage. In order to allow this, it is convenient that the panels with electric energy storage are similar to the standard panels in terms of size.

One problem underlying the present invention, in its various aspects and/or embodiments, is to provide a photovoltaic panel that is capable of remedying one or more of the abovementioned drawbacks.

Such problem is solved by a photovoltaic panel in accordance with claim 1.

In a first aspect, the invention relates to photovoltaic panel comprising a plurality of systems for the optical concentration of light radiation arranged mutually side-by-side and having a respective optical input and a respective optical output, and a plurality of photovoltaic cells respectively arranged at the optical outputs. A respective portion of space outside the concentration systems is delimited by at least two adjacent optical concentration systems and by a plane passing through (or interpolating) said two respective optical outputs.

The panel comprises, arranged in said portion of space, at least one portion of a storage device of electric energy produced by said photovoltaic cells.

According to the Applicant, the placement of at least one portion of the electric energy storage device in the aforesaid portion of space allows an optimal use of the overall space occupied by the panel, since a space is used that is already available following the presence of the optical concentration systems. Indeed, the shape itself of the concentration systems, which have a size at the optical output smaller than the size at the optical input, determines the delimitation of a portion of space between two adjacent concentration systems. In the prior art, such portion of space was not used, or, as in the case of the abovementioned document DE202009006442U, it was used for the purpose of removing and/or exchanging heat. Following the teaching of the present invention, however, such portion of space becomes a useful space for housing the various elements of the storage device, thus making it possible to integrate in the photovoltaic panels the function of storage of the electric energy (e.g. produced by the same panels) without any increase of the overall weight of the panel and/or with a high storage capacity (given the same storage efficiency of the device), all of the above occurring without any negative effect on the electric power of the panel.

Preferably the panel comprises at least one respective portion of the electric energy storage device arranged in a respective portion of space outside the concentration systems and delimited by each pair of adjacent optical concentration systems and by said plane passing through said two respective optical outputs of said pair. Advantageously, in such a manner all the spaces available between each pair of optical concentrators are utilized.

Preferably the panel comprises a further portion of the electric energy storage device interposed between at least two, preferably between each pair of, consecutive photovoltaic cells.

Preferably the panel comprises a still further portion of the electric energy storage device (possibly coinciding with said further portion of the storage device) constituting a rear support element (i.e. opposite the optical inputs) of the panel. Preferably said still further portion of the storage device is extended into a half-space opposite the lying half-space of the optical concentration systems with respect to a lying plane of the photovoltaic cells.

Preferably the electric energy storage device comprises at least one rechargeable battery (e.g. of lithium ion type) and/or at least one supercapacitor.

Preferably the panel comprises an electronic drive and control unit configured for charging and discharging the electric energy storage device (or portions thereof) and, preferably, for optimizing the production of electric energy produced by the panel itself. Preferably the electronic drive and control unit is configured for charging and discharging the storage device in accordance with the requirements of an electrical network connected to the panel such as, for example, the need to maintain constant the electric power delivered by the panel, independent of the insolation conditions.

Preferably the lying plane of each optical output identifies two half-spaces, each respective concentration system entirely extended in the half-space arranged on the side opposite the respective photovoltaic cell with respect to said lying plane of the optical output. Advantageously, in such a manner, a wide space available for the storage device is ensured.

Preferably the optical concentration system has a first extension direction passing through said optical input and said optical output, more preferably orthogonal to the lying plane of said optical output (or to the lying plane that better interpolates the optical output, in case of non-planarity of the latter). Preferably said photovoltaic cell is extended orthogonally to said extension axis.

Preferably the ratio (otherwise known as the geometric gain of the concentration system) between the surface extension of the projection of the optical input on a plane orthogonal to the first extension direction and the surface extension of the projection of the optical output on said orthogonal plane is greater than or equal to 1.5, more preferably greater than or equal to 2, and/or less than or equal to 10, more preferably less than or equal to 5. Advantageously, in such a manner, a good compromise is obtained between acceptance angle of the optical concentration system (with possibility of installation in a static or nearly-static manner) and space available between two adjacent concentration systems.

Preferably each optical concentration system comprises a reflective system delimiting, together with said optical input and said optical output, a space inside the reflective system.

Preferably each optical concentration system comprises a refractive system, more preferably positioned inside said internal space. Advantageously, in such a manner the optical concentration system allows an efficient concentration of the light radiation and at the same time a wide availability of external space between two adjacent reflective systems.

Preferably the refractive system comprises (or even consists of) a body made of transparent dielectric material, with refraction index preferably greater than or equal to 1.3.

Preferably the panel also comprises a heat removal system configured for removing heat from the photovoltaic cells. The heat removal system advantageously maintains the conversion efficiency of the cells over optimal values (since this decreases with the increase of the cell temperature) and also allows the recovery of heat useful for a use thereof (e.g. for producing hot water or for heating).

Preferably the heat removal system comprises a hydraulic duct in thermal contact with at least one (preferably with each) of said photovoltaic cells.

With the expression 'hydraulic duct', it is generally intended a duct capable of conveying the flow of a fluid, such as a liquid (more typically) or a gas.

Preferably, with reference to the orthogonal section, at least one side of said hydraulic duct is in contact (direct or indirect) with said photovoltaic cell, wherein a material layer possibly interposed between said side and said cell is made of a thermally conductive material (e.g. having a thermal conductivity greater than 1 W•m⁻¹•K⁻¹, more preferably greater than or equal to 5 W•m⁻¹•K⁻¹) (and/or it has a thickness less than or equal to 10mm, more preferably less than or equal to 5mm. Preferably said hydraulic duct is filled with a convector fluid, e.g. a mixture comprising water and glycol, in (forced) circulation, during use. Advantageously, in such a manner the removal system is particularly efficient when there is a limited size thereof. The Applicant observes that an efficient heat removal system synergistically interacts with the optical concentration system in the resolution of the problem of increasing the storage capacity of the integrated panel given the same size thereof, since it avoids the use of particularly massive and/or bulky heat dissipation systems (such as suitable dissipater elements, e.g. made of aluminum or similar conductor materials, in thermal contact with the photovoltaic cells on the side opposite the light radiation incidence face). In such a manner, further useful space is freed that can be occupied by the storage device.

Preferably said hydraulic duct has at least one flat face fixed to one face of the respective photovoltaic cell on the side opposite the optical output, for example by means of a thermally conductive glue, possibly with the interposition of an element made of a thermally conductive material.

Preferably said hydraulic duct is made of a thermally conductive material. Preferably the thickness of the walls of said hydraulic duct is less than or equal to 5 mm, more preferably less than or equal to 3 mm.

Alternatively, each hydraulic duct internally houses a respective photovoltaic cell, the hydraulic duct being at least partially transparent and being fixed to the optical concentration system at the respective optical output.

Preferably said hydraulic duct has a perimeter profile on a generic orthogonal section with D-shaped or rectangular form.

Preferably the panel comprises a thermal insulation arranged around at least one portion of the perimeter extension of the hydraulic duct on a generic orthogonal section (said portion not comprising said side in thermal contact with the respective photovoltaic cell, preferably said portion excluding only said side). Preferably said thermal insulation is made of a thermally insulating material (e.g. having a thermal conductivity less than 1 W•m⁻¹•K⁻¹, more preferably less than or equal to 0.1 W•m⁻¹•K⁻¹), such as a solid insulating foam.

In one embodiment, said hydraulic duct is obtained inside the refractive system of the respective concentration system. Advantageously, in such a manner further space is freed for housing the storage device on the side opposite the optical output with respect to the cell. The more external portion of the storage device can thus constitute a rear support element of the panel.

Preferably said hydraulic duct has a perimeter profile on a generic orthogonal section with triangular form.

Preferably the panel comprises a thermal insulation arranged around a portion of the perimeter extension of the photovoltaic cell on the generic orthogonal section outside the side at the optical output.

Preferably the optical concentration system has a main extension direction orthogonal to the first extension direction, the optical concentration system having a profile in section on a section plane orthogonal to said main extension direction. By longitudinal it is intended parallel to the main extension direction.

Preferably the optical concentration system has a profile in section (substantially) unchanging for a continuum of positions of the section plane along at least one portion of the longitudinal extension length of the concentration system, more preferably along substantially the entire longitudinal extension length (possibly except for the longitudinal end faces). Advantageously, in such a manner, the concentration system is of two-dimensional type (2D), i.e. it concentrates the radiation on the generic orthogonal plane and not along the longitudinal direction. This facilitates the possibility of static or near-static ground installation, where the concentration system is oriented with the longitudinal direction according to the east-west geographic direction and with the aforesaid orthogonal plane parallel to the north-south geographic direction.

Preferably, each photovoltaic cell (intending with such term also a substantially continuous strip of separate photovoltaic cells that are electrically connected to each other in series) has a main longitudinal extension direction.

Preferably each portion of the electric energy storage device housed in said portion of space has a main longitudinal extension direction.

Preferably said hydraulic duct is extended along the longitudinal direction.

Preferably each reflective system comprises (or consists of) two subportions arranged on opposite sides with respect to a median plane parallel to the first direction and to the main direction and passing through the median points of the profiles in section of the respective photovoltaic cell. More preferably the two subportions mirror each other with respect to said median plane.

Preferably the mutually facing surfaces of the two subportions of the reflective system have a reflectivity greater than or equal to 95%, more preferably greater than or equal to 99%, still more preferably over the entire visible and near-infrared spectrum (e.g. at least from about 300 nm to about 3000 nm). In such a manner, advantageously, in addition to increasing the concentration efficiency, the passage of heat through the reflective system from the space inside the aforesaid portion of space is also limited.

Preferably said portion of space, for a subportion thereof left free of said storage device portion, is filled with an insulating material, such as a solid insulating foam. Advantageously, the high reflectivity of the reflective system and/or the aforesaid insulating material and/or the thermal insulation of the tube ensures/ensure a suitable thermal insulation for the storage device situated in the portion of space, with the double result of reducing the operating temperature thereof and improving the heat exchange with the convector fluid, limiting the dispersion of the residual heat towards the environment.

Preferably the profile in section of each reflective system comprises (or consists of) two subportions arranged on opposite sides with respect to a median axis (or symmetry axis), the intersection of the aforesaid median plane with the section plane.

In one embodiment, the profile in section of the refractive system is a triangle having a base at the section of the optical output and apex on the symmetry axis. Preferably the profile in section of each subportion of the reflective system is extended from one point in proximity to the respective vertex at the base of the triangle up to an end point on the optical input, and comprises a segment substantially shaped according to a parabola having an axis forming with the symmetry axis an acceptance angle greater than zero and focus on the symmetry axis.

In a further embodiment, the profile in section of the refractive system has a first base, preferably substantially rectilinear, coinciding with the section of the optical output, a second base coinciding with the section of the optical input and a first and second side interposed between, and joining, the first and second base. The profile in section of each half-portion of the reflective system is a segment that is extended to superimpose, or is in the immediate vicinity of, at least one portion of the respective side in a manner so as to reflect an incident radiation towards the refractive system, and having an initial point, coinciding with, or in the immediate vicinity of, a respective first vertex formed by the first base and by the respective side and a final point on the, or in the immediate vicinity of the, respective side.

In a further embodiment, the refractive system comprises a lower portion supporting an upper portion. The minimum width of the lower portion is greater than the maximum width of the upper portion. The optical output lies on a lower side of the lower portion, the minimum width of the lower portion being greater than or equal to the width of the optical output. The profile in section of the upper portion has an aspect ratio (ratio between the height along the first direction and the maximum width) less than or equal to 0.5, preferably less than or equal to 0.3. The profile in section of each half-portion of the reflective system is extended from a respective initial point on an upper side of the lower portion and laterally adjacent to the upper portion or in proximity thereto up to an end point on the optical input, and preferably comprises a segment substantially shaped according to a parabola.

A further aspect not being part of the invention relates to a photovoltaic system comprising at least one panel (more typically a plurality of panels) according to the present invention in the different embodiments and, outside the panel, a hydraulic pump for the forced circulation of said convector fluid in the hydraulic ducts and a heat exchanger for removing heat from said fluid. Preferably said exchanger is comprised in a heat storage, such as an insulated tank. Typically the photovoltaic system comprises an inverter.

Further characteristics and advantages will be clearer from the detailed description of several exemplifying but not exclusive embodiments of a photovoltaic panel in accordance with the present invention. Such description will be set forth hereinbelow with reference to the enclosed figures, provided only for indicative and hence non-limiting purposes, in which:
- figure 1 shows, in orthogonal and partial section, a schematic diagram of a photovoltaic panel in accordance with the present invention;
- figure 2 shows, in partial and schematic orthogonal section, a photovoltaic panel in accordance with a first embodiment of the present invention;
- figure 3 shows, in partial and schematic orthogonal section, a photovoltaic panel in accordance with a second embodiment of the present invention;
- figure 4 shows, in partial and schematic orthogonal section, a photovoltaic panel in accordance with a third embodiment of the present invention;
- figure 5 shows, in partial and schematic orthogonal section, a photovoltaic panel in accordance with a fourth embodiment of the present invention;
- figure 6 shows, in partial and schematic orthogonal section, a photovoltaic panel in accordance with a fifth embodiment of the present invention;
- figure 7 shows, in partial and schematic orthogonal section, a photovoltaic panel in accordance with a sixth embodiment of the present invention.

With reference to the enclosed figures, reference number 1 generically indicates a photovoltaic panel in accordance with the present invention. The same reference number will be used for equivalent or similar elements, also in their different embodiment variants.

The photovoltaic panel 1 comprises a plurality of systems 2 for the optical concentration of the light radiation, arranged mutually side-by-side and having a respective optical input 3 and a respective optical output 4, and a plurality of photovoltaic cells 5 respectively arranged at the optical outputs 4. Preferably the length in orthogonal section of the photovoltaic cells is identical to the length of the optical outputs (as in the illustrated examples).

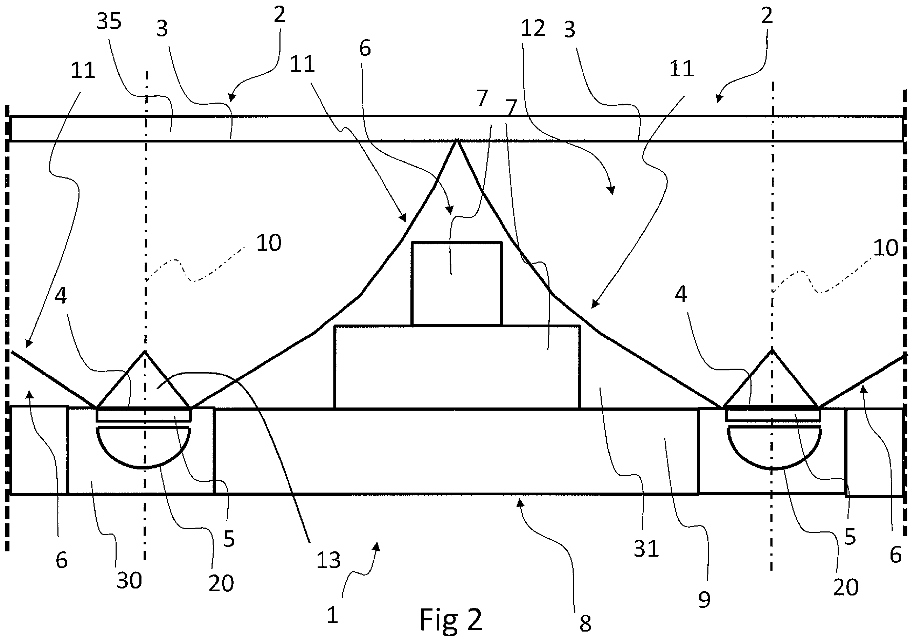

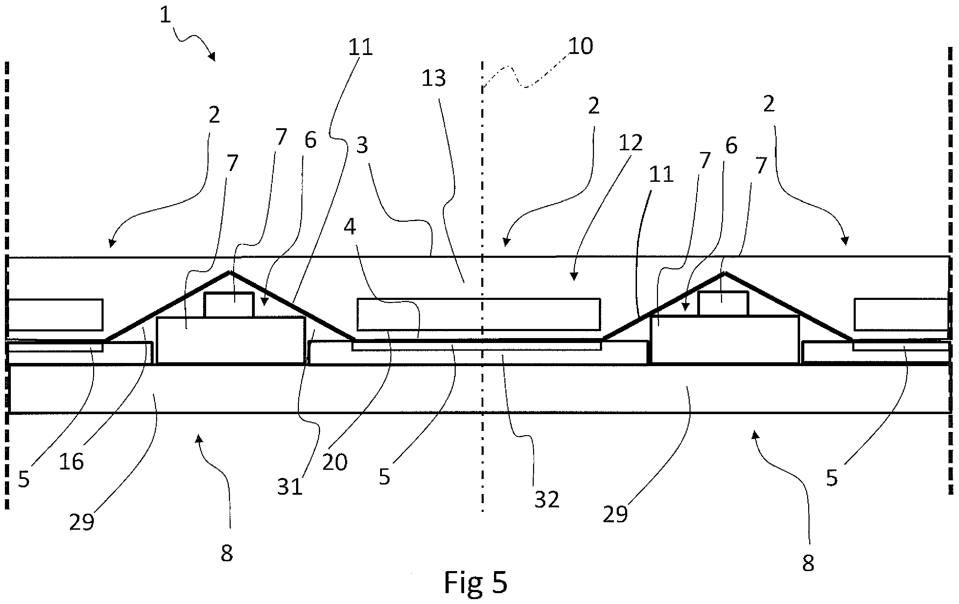

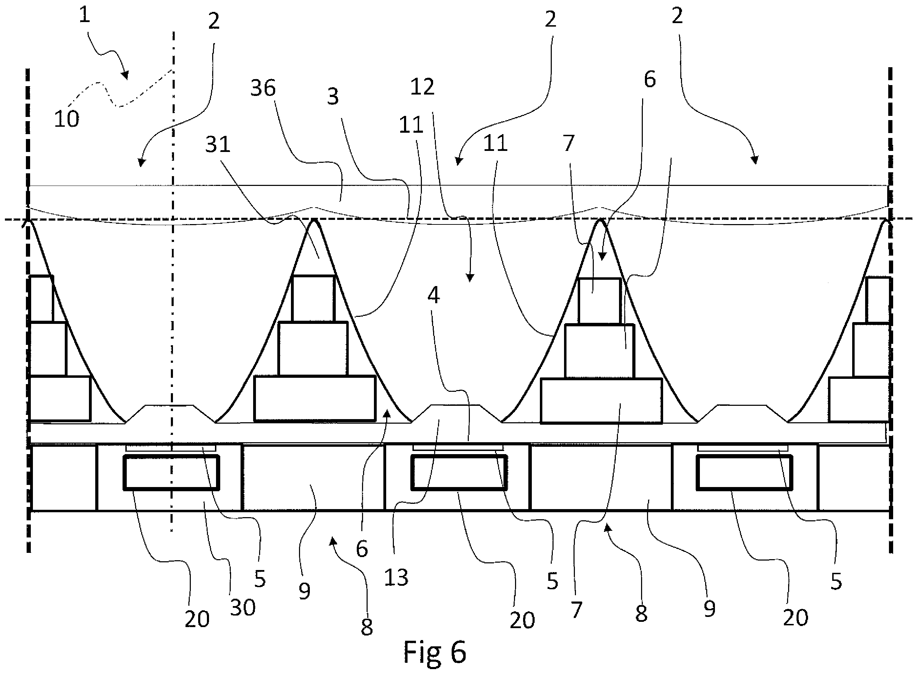

A reduced number of concentration systems 2 are shown in the figures. For example, in figures 2 and 3, only two concentration systems are shown and each only partially; in figures 4 and 5 three systems are shown of which only the central one is illustrated with its entire orthogonal extension; and in figures 5 and 6 three systems 2 are shown with their entire orthogonal extension. Typically, for manufacturing convenience and for optimizing performances, the concentration systems (like the photovoltaic cells, the relative storage device portions and the relative ducts) are all identical to each other.

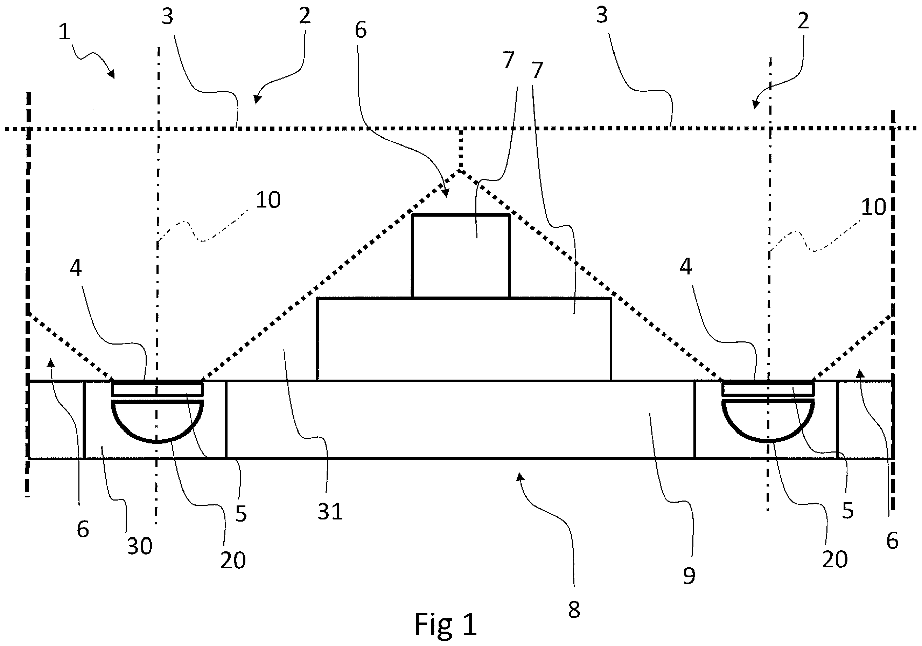

Shown in figure 1, with dotted lines and only for illustration purposes, are the possible overall footprint areas of the concentration systems 2; the relative constituent structures are not illustrated.

The present invention considers concentration systems 2 of any structure, shape, material and performance, so long as the geometric gain is greater than 1 and hence the optical output less extensive than the optical input. In such a manner, a respective portion of space 6 outside the concentration systems 2 is to be delimited by at least two adjacent optical concentration systems 2 and by a plane passing through (or interpolating, in the case of non-planar outputs) the two respective optical outputs 4. Such portion of space can be physically delimited by the two adjacent concentration systems, as in the examples of figures 2-6, or it can be delimited by the useful optical paths of the concentration systems (in the sense that such useful optical paths do not invade said portion of space 6), for example in the case of refractive-only concentration systems as in the abovementioned document WO2012/017274A1

Preferably, the lying plane of each optical output 4 identifies two half-spaces (in the figures, corresponding to two half-planes lying on the lying plane of the figures), each respective concentration system 2 fully extended in the half-space arranged on the side opposite the respective photovoltaic cell 5 with respect to said lying plane of the optical output.

Preferably the panel 1 comprises at least one portion 7 of an electric energy storage device 8, said portion 7 being arranged in said portion of space 6.

Preferably said portion of space 6, for a subportion thereof left free of said storage device portion 7, is filled with an insulating material 31, such as a solid insulating foam.

Preferably the panel comprises a further portion 9 of the electric energy storage device 8 interposed between at least two, preferably between each pair of, adjacent photovoltaic cells.

Preferably the panel comprises a still further portion 29 of the electric energy storage device 8 constituting a rear support element (i.e. opposite the optical inputs) of the panel. Preferably said still further portion 29 of the storage device is only extended into a half-space opposite the lying half-space of the optical concentration systems with respect to a lying plane of the photovoltaic cells.

The present invention considers any type of electric energy storage device, for example with rechargeable batteries (e.g. of lithium ion or lithium-polymer type) or with supercapacitors.

Preferably the panel comprises (not shown, for example arranged at a side or portion or at a corner of the panel as seen in plan view) an electronic drive and control unit configured for optimizing the production of electric energy produced by the panel itself and for charging and discharging the electric energy storage device (or portions thereof). For example, the electronic drive and control unit is configured for charging and discharging the storage device on the basis of a predetermined sequence or on the basis of external commands. Preferably the electronic drive and control unit comprises a system for optimizing the electric power produced by the panel and a system for communicating towards a control element of the photovoltaic system comprising multiple photovoltaic panels.

Preferably the optical concentration system has a first extension direction 10 (lying on the lying plane of the figures) passing through said optical input and said optical output, typically orthogonal to the lying plane of the optical output, of the optical input and of the photovoltaic cell.

Preferably, as in the illustrated examples, the concentration system has low concentration; nevertheless, the present invention also considers systems with medium or high concentration (e.g. the ratio between the width in section of the optical input and the optical output greater than 10).

As mentioned above, the concentration system can have any structure, for example it can only be refractive (e.g. having a primary refractive optics on the input and a secondary refractive optics at the output, as in the abovementioned document WO2012/017274A1), or only reflective, or it can be mixed (as in the mentioned examples).

A mixed concentration system 2 comprises a reflective system 11 delimiting, together with said optical input and said optical output, a space 12 inside the reflective system and a refractive system 13 (e.g. a body made of glass or PMMA with 1.5 refraction index) positioned inside said internal space 12.

In addition, the concentration system can be of 3D type (concentration on two planes that are orthogonal to each other) or (in a preferred form) 2D type (concentration on only one plane), in which the profile in section of the concentration system on a section plane (e.g. the lying plane of the figures) orthogonal to a main extension direction (e.g. orthogonal to the lying plane of the figures) is unchanging for a continuum of positions of the section plane along substantially the entire longitudinal extension length.

Preferably, the entire panel 1 (including the photovoltaic cells, the storage device and the heat removal system) has a profile in section substantially unchanging over the entire longitudinal extension length.

Preferably the panel also comprises a heat removal system comprising, for each photovoltaic cell 5, a hydraulic duct 20 in thermal contact with the photovoltaic cell and filled, during use, with a convector fluid, e.g. a mixture of water and glycol (e.g. for anti-freeze purposes), in circulation (e.g. forced).

Preferably at least one side of the hydraulic duct 20 is in contact (direct or indirect, for example with the interposition of a conductive glue layer and/or of an element with high thermal conductivity, not shown in figures 1, 2, 4 and 6, or of a refractive material layer as shown in figures 3, 5 and 7) with the photovoltaic cell.

Preferably, as shown in the examples of figures 1, 2, 4 and 6, the hydraulic duct has at least one flat face (corresponding to a rectilinear side in the figures in section) fixed to the face of the respective photovoltaic cell on the side opposite the optical output, for example by means of a thermally conductive glue, possibly with the interposition of an element made of a high conductivity material (not shown). In such case, the duct can be made of a material with high conductivity such as brass, aluminum or steel.

In an alternative embodiment, not shown, each hydraulic duct (which in such case can also be entirely insulated and/or made of insulating material) internally houses a respective photovoltaic cell, the hydraulic duct being at least partially transparent and being fixed (e.g. with a transparent glue) to the optical concentration system at the respective optical output.

Preferably the hydraulic duct has a perimeter profile with D-shaped form.

Preferably the panel comprises a thermal insulation 30 arranged around the portion of the perimeter extension of the hydraulic duct outside the side in thermal contact with the respective photovoltaic cell.

In one embodiment (as shown as an example in figures 3, 5 and 7), the hydraulic duct 20 is obtained inside the refractive system 13 of the concentration system. Such solution can also be combined with the ducts as shown and described with reference to figures 1, 2, 4 and 6, in a manner such that two hydraulic ducts are arranged on opposite sides of the cell.

The more external portion of the storage device (i.e. said still further portion 29) can thus constitute a rear support element of the panel.

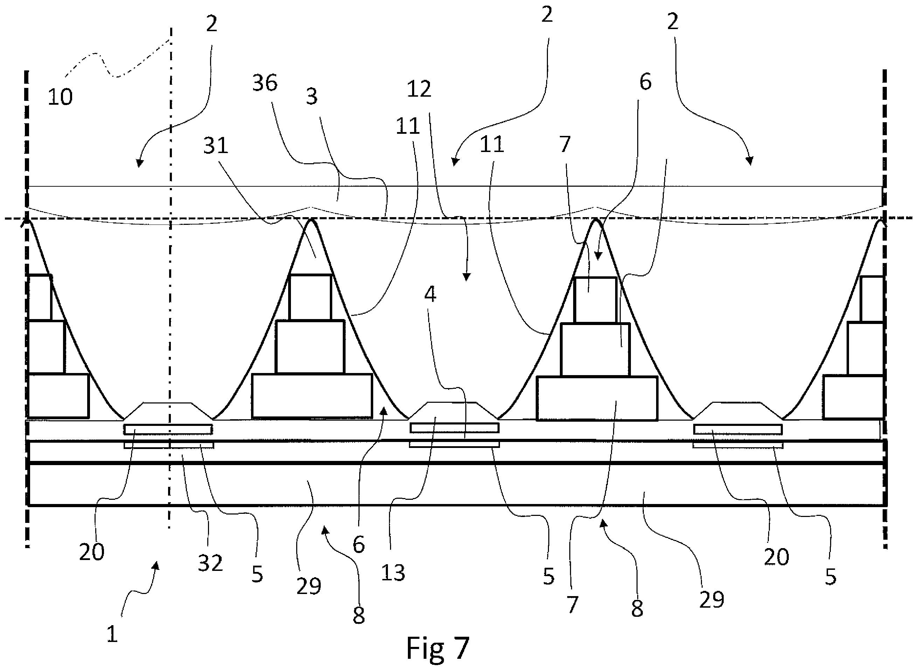

In other embodiments, the hydraulic duct 20 has a perimeter profile with triangular shape (fig. 3) or rectangular shape (fig. 5 and fig. 7).

Preferably the panel comprises a thermal insulation 32 arranged around the portion of the perimeter extension of the photovoltaic cell outside the side placed at the optical output.

Preferably the profile in section of each reflective system 11 consists of two subportions arranged on opposite sides with respect to a median axis 10 parallel to the first direction and passing through the median point of the profile in section of the photovoltaic cell, the intersection of the aforesaid median plane with the section plane.

Preferably the two subportions mirror each other with respect to said median plane.

As shown as an example in figures 2 and 3, in one embodiment the profile in section of the refractive system 13 is a triangle having a base at the section of the optical output and apex on the symmetry axis 10. The profile in section of each subportion of the reflective system 11 is extended from one point in proximity to the respective vertex at the base of the triangle up to an end point on the optical input, and comprises a segment substantially shaped according to a parabola having an axis forming with the symmetry axis an acceptance angle greater than zero and focus on the symmetry axis. As an example, a lid 35 made of transparent material closes the internal spaces 12 of the reflective systems.

Further details of one such concentration system are contained in the abovementioned documents AU-A-70929/87 and WO 2013/030720A1.

As shown as an example in figures 4 and 5, in one embodiment the profile in section of the refractive system 13 has a first base, preferably substantially rectilinear, coinciding with the section of the optical output 4, a second base coinciding with the section of the optical input 3 and a first and second side interposed between, and joining, the first and second base. The profile in section of each half-portion of the reflective system 11 is a segment (e.g. rectilinear) that is extended to superimpose, or is in the immediate vicinity of, at least one portion of the respective side of the refractive system in a manner so as to reflect an incident radiation towards the refractive system, and having an initial point, coinciding with, or in the immediate vicinity of, a respective first vertex formed by the first base and by the respective side and a final point on the, or in the immediate vicinity of the, respective side.

Further details of one such concentration system are contained in the abovementioned document MI2011A002294.

As shown as an example in figures 6 and 7, in one embodiment the refractive system 13 comprises a lower portion supporting an upper portion (e.g. in a single piece with the lower portion). The minimum width of the lower portion is greater than the maximum width of the upper portion. The optical output 4 lies on a lower side of the lower portion, the minimum width of the lower portion being greater than or equal to the width of the optical output. The profile in section of the upper portion (e.g. with trapezoidal form) has an aspect ratio (ratio between the height along the first direction 10 and the maximum width) less than or equal to 0.5, preferably less than or equal to 0.3. The profile in section of each half-portion of the reflective system is extended from a respective initial point on an upper side of the lower portion and laterally adjacent to the upper portion or in proximity thereto up to an end point on the optical input, and preferably comprises a segment substantially shaped according to a parabola.

As an example, a lid 36 made of transparent material closes the internal spaces 12 of the reflective systems and introduces a further refraction by means of a converging lens profile.

## Claims

1. Photovoltaic panel (1) comprising a plurality of optical concentration systems (2) arranged mutually side-by-side and having a respective optical input (3) and a respective optical output (4), and a plurality of photovoltaic cells (5) respectively arranged at the optical outputs, wherein a respective portion of space (6) outside the concentration systems is delimited by at least two adjacent optical concentration systems (2) and by a plane passing through said two respective optical outputs, **characterized in that** the panel comprises, arranged in said portion of space (6), at least one portion (7) of a storage device (8) of electric energy produced by said photovoltaic cells (5).

2. Panel according to claim 1, comprising a respective portion (7) of a plurality of electric energy storage devices (8) arranged in their respective portion of space (6) outside the concentration systems and delimited by each pair of adjacent concentration systems and by said plane passing through said two respective optical outputs (4) of said pair.

3. Panel according to claim 1 or 2, comprising a further portion (9) of the electric energy storage device interposed between at least two consecutive photovoltaic cells and/or comprising a still further portion (29) of the electric energy storage device (8) constituting a rear support element of the panel, wherein said still further portion (29) of the storage device is only extended into a half-space opposite the lying half-space of the optical concentration systems with respect to a lying plane of the photovoltaic cells.

4. Panel according to any one of the preceding claims, wherein the geometric gain is greater than or equal to 1.5 and/or less than or equal to 10 and wherein the panel comprises an electronic drive and control unit configured for charging and discharging at least one portion of the electric energy storage device.

5. Panel according to any one of the preceding claims, further comprising a heat removal system configured for removing heat from the photovoltaic cells, wherein the heat removal system comprises a hydraulic duct (20) in thermal contact with at least one of said photovoltaic cells,
wherein said hydraulic duct (20) has at least one flat face fixed to one face of the respective at least one photovoltaic cell (5) on the side opposite the optical output (4) and wherein said hydraulic duct is made of a thermally conductive material.

6. Panel according to any of the claims from 1 to 4, further comprising a heat removal system configured for removing heat from the photovoltaic cells, wherein the heat removal system comprises a hydraulic duct (20) in thermal contact with at least one of said photovoltaic cells,
wherein each hydraulic duct (20) internally houses a respective photovoltaic cell (5), the hydraulic duct being at least partially transparent and being fixed to the optical concentration system at the respective optical output (4).

7. Panel according to claims 5 or 6, further comprising a thermal insulation (30) arranged around at least one portion of the perimeter extension of the hydraulic duct (20) on the generic orthogonal section, wherein said thermal insulation is made of a thermally insulating material having a thermal conductivity less than 0.1 W•m⁻¹•K⁻¹.

8. Panel according to any one of the claims from 5 to 7, wherein said hydraulic duct (20) is obtained inside a refractive system (13) of the respective concentration system.

9. Panel according to any one of the preceding claims, wherein the panel comprises a thermal insulation (32) arranged around a portion of the perimeter extension of the photovoltaic cell on the generic orthogonal section outside the side of the photovoltaic cell (5) placed at the optical output (4).

10. Panel according to any one of the preceding claims, wherein the optical concentration system (2) has a main extension direction and wherein the optical concentration system has a profile in section substantially unchanging for a continuum of positions of the section plane along substantially the entire longitudinal extension length of the concentration system.

11. Panel according to any one of the preceding claims, wherein said portion of space (6), for a subportion thereof left free from said portion (7) of the storage device (8), is filled with a thermally insulating material (31).

12. Panel according to any one of the preceding claims, wherein each optical concentration system (2) comprises a reflective system (11) delimiting, together with said optical input and said optical output, a space (12) inside the reflective system, wherein each optical concentration system comprises a refractive system (13) positioned inside said internal space, wherein each reflective system comprises two subportions with main longitudinal extension arranged on opposite sides with respect to a median plane parallel to the first direction and to the main direction and passing through the median points of the profiles in section of the respective photovoltaic cell and wherein the mutually facing surfaces of the two subportions of the reflective system have a reflectivity greater than or equal to 95% at least for a spectrum portion ranging from about 300 nm to about 2000 nm.

13. Panel according to claim 12, wherein the profile in section of the refractive system (13) is a triangle having a base at the section of the optical output (4) and apex on a symmetry axis (10), wherein the profile in section of each subportion of the reflective system (11) is extended from one point in proximity to the respective vertex at the base of the triangle up to an end point on the optical input (3), and comprises a segment substantially shaped according to a parabola having an axis forming with the symmetry axis an acceptance angle greater than zero and focus on the axis of symmetry.

14. Panel according to claim 12, wherein the profile in section of the refractive system (13) has a first base, substantially rectilinear, coinciding with the section of the optical output (4), a second base coinciding with the section of the optical input (3) and a first and a second side interposed between, and joining, the first and second base, wherein the profile in section of each half-portion of the reflective system is a segment that is extended to superimpose, or is in the immediate vicinity of, at least one portion of the respective side in a manner so as to reflect an incident radiation towards the refractive system, and having an initial point, coinciding with, or in the immediate vicinity of, a respective first vertex formed by the first base and by the respective side and a final point on the respective side or in the immediate vicinity thereof.

15. Panel according to claim 12, wherein the profile in section of the refractive system (13) comprises a lower portion supporting an upper portion, wherein the minimum width of the lower portion is greater than the maximum width of the upper portion, wherein the section of the optical output (4) lies on a lower side of the lower portion, the minimum width of the lower portion being greater than or equal to the width of the section of the optical output, wherein the profile in section of the upper portion has a ratio between the height along the first direction and the maximum width less than or equal to 0.5, and wherein the profile in section of each half-portion of the reflective system is extended from a respective initial point on an upper side of the lower portion and laterally adjacent to the upper portion or in proximity thereto up to an end point on the optical input, and preferably comprises a segment substantially shaped according to a parabola.

## Patentansprüche

1. Photovoltaikpaneel (1) umfassend mehrere optische Konzentrationssysteme (2), die gegenseitig nebeneinander angeordnet sind und einen jeweiligen optischen Eingang (3) und einen jeweiligen optischen Ausgang (4) aufweisen, und mehrere Photovoltaikzellen (5), die jeweils an den optischen Ausgängen angeordnet sind, wobei ein jeweiliger Abschnitt des Raums (6) außerhalb der Konzentrationssysteme durch mindestens zwei benachbarte optische Konzentrationssysteme (2) und durch eine Ebene, die durch die beiden jeweiligen optischen Ausgänge verläuft, begrenzt ist, **dadurch gekennzeichnet, dass** das Paneel in dem Abschnitt des Raums (6) angeordnet mindestens einen Abschnitt (7) einer Speichervorrichtung (8) der von den Photovoltaikzellen (5) erzeugten elektrische Energie umfasst.

2. Paneel nach Anspruch 1, umfassend einen jeweiligen Abschnitt (7) von mehreren Speichervorrichtungen elektrischer Energie (8), die in ihrem jeweiligen Abschnitt des Raums (6) außerhalb der Konzentrationssysteme angeordnet sind und durch jedes Paar benachbarter Konzentrationssysteme und durch die Ebene, die durch die beiden jeweiligen optischen Ausgänge (4) des Paares verläuft, begrenzt sind.

3. Paneel nach Anspruch 1 oder 2, umfassend einen weiteren Abschnitt (9) der Speichervorrichtung elektrischer Energie, der zwischen mindestens zwei aufeinanderfolgenden Photovoltaikzellen angeordnet ist und/oder noch einen weiteren Abschnitt (29) der Speichervorrichtung elektrischer Energie (8) umfasst, der ein hinteres Trägerelement des Paneels bildet, wobei sich der weitere Abschnitt (29) der Speichervorrichtung nur in einen Halbraum gegenüber dem liegenden Halbraum der optischen Konzentrationssysteme bezüglich einer liegenden Ebene der Photovoltaikzellen erstreckt.

4. Paneel nach einem der vorhergehenden Ansprüche, wobei die geometrische Verstärkung größer oder gleich 1,5 und/oder kleiner oder gleich 10 ist und wobei das Paneel eine elektronische Antriebs- und Steuereinheit umfasst, die zum Laden und Entladen mindestens eines Teils der Speichervorrichtung elektrischer Energie konfiguriert ist.

5. Paneel nach einem der vorhergehenden Ansprüche, ferner umfassend ein Wärmeabfuhrsystem, das zum Abführen von Wärme aus den Photovoltaikzellen konfiguriert ist, wobei das Wärmeabfuhrsystem einen Hydraulikkanal (20) in thermischem Kontakt mit mindestens einer der Photovoltaikzellen umfasst, wobei der Hydraulikkanal (20) mindestens eine flache Fläche aufweist, die an einer Fläche der jeweiligen mindestens einen Photovoltaikzelle (5) auf der dem optischen Ausgang (4) gegenüberliegenden Seite befestigt ist, und wobei der Hydraulikkanal aus einem wärmeleitenden Material besteht.

6. Paneel nach einem der Ansprüche von 1 bis 4, ferner umfassend ein Wärmeabfuhrsystem, das zum Abführen von Wärme aus den Photovoltaikzellen konfiguriert ist, wobei das Wärmeabfuhrsystem einen Hydraulikkanal (20) in thermischem Kontakt mit mindestens einer der Photovoltaikzellen umfasst, wobei jeder Hydraulikkanal (20) intern eine jeweilige Photovoltaikzelle (5) beherbergt, wobei der Hydraulikkanal zumindest teilweise transparent ist und am optischen Konzentrationssystem am jeweiligen optischen Ausgang (4) befestigt ist.

7. Paneel nach einem der Ansprüche 5 bis 6, ferner umfassend eine Wärmedämmung (30), die um mindestens einen Abschnitt der Umfangsausdehnung des Hydraulikkanals (20) auf dem generischen orthogonalen Abschnitt angeordnet ist, wobei die Wärmedämmung aus einem wärmedämmenden Material hergestellt ist, das eine Wärmeleitfähigkeit von weniger als 0,1 W•m⁻¹•K⁻¹ aufweist.

8. Paneel nach einem der Ansprüche 5 bis 7, wobei der Hydraulikkanal (20) innerhalb eines Brechungssystems (13) des jeweiligen Konzentrationssystems erhalten wird.

9. Paneel nach einem der vorhergehenden Ansprüche, wobei das Paneel eine Wärmedämmung (32) umfasst, die um einen Abschnitt der Umfangsausdehnung der Photovoltaikzelle auf dem generischen orthogonalen Abschnitt außerhalb der Seite der am optischen Ausgang (4) platzierten Photovoltaikzelle (5) angeordnet ist.

10. Paneel nach einem der vorhergehenden Ansprüche, wobei das optische Konzentrationssystem (2) eine Hauptausdehnungsrichtung aufweist und wobei das optische Konzentrationssystem ein Profil im Abschnitt aufweist, das sich für ein Kontinuum von Positionen der Abschnittsebene entlang im Wesentlichen der gesamten Längsausdehnungslänge des Konzentrationssystems im Wesentlichen nicht ändert.

11. Paneel nach einem der vorhergehenden Ansprüche, wobei der Abschnitt des Raums (6) für einen Teil davon, der von dem Abschnitt (7) der Speichervorrichtung (8) frei bleibt, mit einem wärmedämmenden Material (31) gefüllt ist.

12. Paneel nach einem der vorhergehenden Ansprüche, wobei jedes optische Konzentrationssystem (2) ein reflektierendes System (11) umfasst, das zusammen mit dem optischen Eingang und dem optischen Ausgang einen Raum (12) innerhalb des reflektierenden Systems begrenzt, wobei jedes optische Konzentrationssystem ein Brechungssystem (13) umfasst, das innerhalb des Innenraums positioniert ist, wobei jedes reflektierende System zwei Unterabschnitte umfasst, bei denen die Hauptlängsausdehnung auf gegenüberliegenden Seiten bezüglich einer Mittelebene parallel zur ersten Richtung und zur Hauptrichtung angeordnet ist und durch die Mittelpunkte der Profile im Abschnitt der jeweiligen Photovoltaikzelle verläuft, und wobei die einander zugewandten Oberflächen der beiden Unterabschnitte des reflektierenden Systems ein Reflexionsvermögen von mehr als oder gleich 95 % aufweisen, zumindest für einen Spektralabschnitt im Bereich von etwa 300 nm bis etwa 2000 nm.

13. Paneel nach Anspruch 12, wobei das Profil im Abschnitt des Brechungssystems (13) ein Dreieck ist, das eine Basis am Abschnitt des optischen Ausgangs (4) und einen Scheitelpunkt auf einer Symmetrieachse (10) aufweist, wobei sich das Profil im Abschnitt jedes Unterabschnitts des reflektierenden Systems (11) von einem Punkt in der Nähe der jeweiligen Ecke an der Basis des Dreiecks bis zu einem Endpunkt am optischen Eingang (3) erstreckt und ein Segment umfasst, das im Wesentlichen gemäß einer Parabel geformt ist, die eine Achse aufweist, die mit der Symmetrieachse einen Öffnungswinkel größer als Null bildet und den Brennpunkt auf der Symmetrieachse hat.

14. Paneel nach Anspruch 12, wobei das Profil im Abschnitt des Brechungssystems (13) eine erste Basis aufweist, die im Wesentlichen geradlinig ist und mit dem Abschnitt des optischen Ausgangs (4) übereinstimmt, eine zweite Basis, die mit dem Abschnitt des optischen Eingangs (3) übereinstimmt, und eine erste und eine zweite Seite, die zwischen der ersten und zweiten Basis angeordnet sind und diese verbinden, wobei das Profil im Abschnitt jedes Halbabschnitts des reflektierenden Systems ein Segment ist, das sich zum Überlagern von mindestens einem Abschnitt der jeweiligen Seite erstreckt oder sich in dessen unmittelbarer Nähe befindet, um eine einfallende Strahlung in Richtung des Brechungssystems zu reflektieren, und einen Anfangspunkt aufweist, der mit einer jeweiligen ersten Ecke übereinstimmt oder in unmittelbarer Nähe davon liegt, die durch die erste Basis und durch die jeweilige Seite und einem Endpunkt auf der jeweiligen Seite oder in unmittelbarer Nähe davon gebildet wird.

15. Paneel nach Anspruch 12, wobei das Profil im Abschnitt des Brechungssystems (13) einen unteren Abschnitt umfasst, der einen oberen Abschnitt trägt, wobei die minimale Breite des unteren Abschnitts größer als die maximale Breite des oberen Abschnitts ist, wobei der Abschnitt des optischen Ausgangs (4) auf einer unteren Seite des unteren Abschnitts liegt, wobei die minimale Breite des unteren Abschnitts größer als oder gleich der Breite des Abschnitts des optischen Ausgangs ist, wobei das Profil im Abschnitt des oberen Abschnitts ein Verhältnis zwischen der Höhe entlang der ersten Richtung und der maximalen Breite von kleiner als oder gleich 0,5 aufweist, und wobei das Profil im Abschnitt jedes Halbabschnitts des reflektierenden Systems sich von einem jeweiligen Anfangspunkt auf einer oberen Seite des unteren Abschnitts und seitlich angrenzend an den oberen Abschnitt oder in der Nähe davon bis zu einem Endpunkt auf dem optischen Eingang erstreckt und vorzugsweise ein Segment umfasst, das im Wesentlichen gemäß einer Parabel geformt ist.

## Revendications

1. Panneau photovoltaïque (1) comprenant une pluralité de systèmes de concentration optique (2) disposés mutuellement côte-à-côte et ayant une entrée optique respective (3) et une sortie optique respective (4), et une pluralité de cellules photovoltaïques (5) disposées respectivement au niveau des sorties optiques, une partie d'espace respective (6) à l'extérieur des systèmes de concentration est délimitée par au moins deux systèmes de concentration optiques adjacents (2) et par un plan passant par lesdites deux sorties optiques respectives, **caractérisé en ce que**
le panneau comprend, disposé dans ladite partie d'espace (6), au moins une partie (7) d'un dispositif de stockage (8) d'énergie électrique produite par lesdites cellules photovoltaïques (5).

2. Panneau selon la revendication 1, comprenant une partie respective (7) d'une pluralité de dispositifs de stockage d'énergie électrique (8) disposés dans leur portion d'espace (6) respective à l'extérieur des systèmes de concentration et délimités par chaque paire de systèmes de concentration adjacents et par ledit plan passant à travers lesdites deux sorties optiques respectives (4) de ladite paire.

3. Panneau selon la revendication 1 ou 2, comprenant une partie supplémentaire (9) du dispositif de stockage d'énergie électrique interposé entre au moins deux cellules photovoltaïques consécutives et/ou comprenant une partie restante (29) du dispositif de stockage d'énergie électrique (8) constituant un élément de support arrière du panneau, dans lequel ladite partie supplémentaire (29) restante du dispositif de stockage est seulement prolongée dans un demi-espace en face du demi-espace en face du demi-espace allongé des systèmes de concentration optique par rapport à un plan allongé des cellules photovoltaïques.

4. Panneau selon l'une quelconque des revendications précédentes, dans lequel le gain géométrique est supérieur ou égal à 1,5 et/ou inférieur ou égal à 10 et dans lequel le panneau comprend un lecteur électronique et une unité de commande configurés pour charger et décharger au moins une partie du dispositif de stockage d'énergie électrique.

5. Panneau selon l'une quelconque des revendications précédentes, comprenant en outre un système d'évacuation de la chaleur configuré pour évacuer la chaleur des cellules photovoltaïques, dans lequel le système d'évacuation de la chaleur comprend un conduit hydraulique (20) en contact thermique avec au moins l'une desdites cellules photovoltaïques,
dans lequel ledit conduit hydraulique (20) a au moins une face plane fixée à une face de la au moins une cellule photovoltaïque respective (5) du côté opposé à la sortie optique (4) et dans lequel ledit conduit hydraulique est constitué d'un matériau thermiquement conducteur.

6. Panneau selon l'une quelconque des revendications 1 à 4, comprenant en outre un système d'évacuation de la chaleur configuré pour évacuer la chaleur des cellules photovoltaïques, dans lequel le système d'évacuation de la chaleur comprend un conduit hydraulique (20) en contact thermique avec au moins l'une desdites cellules photovoltaïques,
dans lequel chaque conduit hydraulique (20) abrite en son sein une cellule photovoltaïque respective (5), le conduit hydraulique étant au moins partiellement transparent et étant fixé au système de concentration optique au niveau de la sortie optique respective (4).

7. Panneau selon les revendications 5 ou 6, comprenant en outre un isolant thermique (30) disposé autour d'au moins une partie de l'extension périmétrique du conduit hydraulique (20) sur la section orthogonale générique, dans lequel ledit isolant thermique est constitué d'un matériau isolant thermique ayant une conductivité thermique inférieure à 0.1 W•m⁻¹•K⁻¹.

8. Panneau selon l'une quelconque des revendications 5 à 7, dans lequel ledit conduit hydraulique (20) est obtenu à l'intérieur d'un système réfractif (13) du système de concentration respectif.

9. Panneau selon l'une quelconque des revendications précédentes, dans lequel le panneau comprend un isolant thermique (32) disposé autour d'une partie de l'extension périmétrique de la cellule photovoltaïque sur la section orthogonale générique à l'extérieur du côté de la cellule photovoltaïque (5) placé au niveau de la sortie optique (4).

10. Panneau selon l'une quelconque des revendications précédentes, dans lequel le système de concentration optique (2) a une direction principale d'extension et dans lequel le système de concentration optique a un profilé en coupe pratiquement inchangé pour un continuum de positions du plan en coupe le long sensiblement de la longueur d'extension longitudinale entière du système de concentration.

11. Panneau selon l'une quelconque des revendications précédentes, dans lequel ladite partie d'espace (6), pour une sous-partie de celle-ci laissée libre de ladite partie (7) du dispositif de stockage (8) est remplie d'un matériau thermiquement isolant (31).

12. Panneau selon l'une quelconque des revendications précédentes, dans lequel chaque système de concentration optique (2) comprend un système réfléchissant (11) délimitant, conjointement avec ladite entrée optique et ladite sortie optique, un espace (12) à l'intérieur du système réfractif, dans lequel chaque système de concentration optique comprend un système réfléchissant (13) positionné à l'intérieur dudit espace interne, dans lequel chaque système réfléchissant comprend deux sous-portions avec extension longitudinale principale, disposés sur les côtés opposés par rapport à un plan médian parallèle à la première direction et à la direction principale et passant par les points médians des profils en coupe de la cellule photovoltaïque respective et dans lequel les surfaces se faisant face des deux sous-portions du système réfléchissant ont une réflectivité supérieure ou égale à 95% au moins pour une partie de spectre allant d'environ 300 nm à environ 2000 nm.

13. Panneau selon la revendication 12, dans lequel le profilé en coupe du système réfractif (13) est un triangle ayant une base au niveau de la section de la sortie optique (4) et un sommet sur un axe de symétrie (10), dans lequel le profilé en coupe de chaque sous- partie du système réfléchissant (11) est étendu d'un point à proximité du sommet respectif à la base du triangle jusqu'à un point d'extrémité sur la sortie optique (3), et comprend un segment sensiblement en forme de parabole ayant un axe formant le symétrique un angle d'acceptation supérieur à 0 et se concentrer sur l'axe de symétrie.

14. Panneau selon la revendication 12, dans lequel le profilé en coupe du système réfractif (13) possède une première base, sensiblement rectiligne, coïncidant avec la section de la sortie optique (4), une seconde base coïncidant avec la section de l'entrée optique (3) et un premier et second côté interposés entre, et joignant, la première et la deuxième base, dans lequel le profilé en coupe de chaque demi-partie du système réfléchissant est un segment qui s'étend pour se superposer ou se trouve à proximité immédiate d'au moins une partie du côté respectif de manière à réfléchir un rayonnement incident vers le système réfractif et ayant un point initial, coïncidant avec, ou à proximité immédiate de, un premier sommet respectif formé par la première base et par le côté respectif et un point final sur le côté respectif ou à proximité immédiate de celui-ci.

15. Panneau selon la revendication 12, dans lequel le profilé en coupe du système réfractif (13) comprend une partie inférieure supportant une partie supérieure, dans lequel la largeur minimum de la partie inférieure est supérieur à la largeur maximum de la partie supérieure, dans lequel la section de la sortie optique (4) se situe sur le côté inférieur de la partie supérieure, la largeur minimum de la partie supérieure étant supérieure ou égale à la largeur de la section de la sortie optique, dans lequel le profilé en coupe de la partie supérieure a un rapport entre la hauteur le long de la première direction et la largeur maximale inférieure ou égale à 0,5, et dans lequel le profilé en coupe de chaque demi-partie du système réfléchissant s'étend depuis un point initial respectif
sur un côté supérieur de la partie inférieure et se raccordant latéralement à la partie supérieure ou à proximité de celle-ci jusqu'au point final de l'entrée optique et comprend de préférence un segment sensiblement façonné selon une parabole.
